# EUROPEAN PATENT APPLICATION

(11) **EP 1 965 435 A1**
(43) Date of publication of application: **03.09.2008**
(21) Application number: 06821934.4
(22) Date of filing: 18.10.2006
(51) Int. Cl.: H01L 29/78, H01L 21/28, H01L 21/336, H01L 21/8238, H01L 27/092, H01L 29/423, H01L 29/49

(54) **SEMICONDUCTOR DEVICE AND METHOD FOR MANUFACTURING SAME**

(30) Priority: 28.11.2005 JP 2005341906
(71) Applicant: NEC Corporation, Minato-ku Tokyo 108-8001 (JP)
(72) Inventor: TAKAHASHI, Kensuke, Tokyo 108-8001 (JP)
(74) Representative: Wenzel & Kalkoff
(86) International application number: PCT/JP2006/320740
(87) International publication number: WO 2007/060797

(57) **Abstract**

A semiconductor device including a silicon substrate; a gate insulating film on the silicon substrate; a gate electrode on the gate insulating film; and source/drain regions formed in the substrate on both sides of the gate electrode, wherein the gate electrode includes a first silicide layered region formed of a silicide of a metal M1; and a second silicide layered region on the first silicide layered region, the second silicide layered region being formed of a silicide of the same metal as the metal M1 and being lower in resistivity than the first silicide layered region.

## Description

### Technical Field

The present invention relates to a semiconductor device and a manufacturing method thereof, and more particularly to a technique for enhancing the performance and reliability of MOSFETs (metal oxide semiconductor field effect transistors) using a high dielectric constant material for gate insulating films and a silicide material for gate electrodes.

### Background Art

In the development of cutting-edge CMOS (complementary MOS) devices for which smaller and smaller transistors are required, the deterioration of the driving current due to the depletion of polycrystalline silicon (poly-Si) electrodes and an increase of the gate leak current due to the thinning of the gate insulating film are posing problems. In view of these problems, a combined technique of avoiding the depletion of electrodes by applying metal gate electrodes and of reducing the gate leak current by increasing the physical film thickness by using a high dielectric constant material for the gate insulating film is being studied.

The materials considered for use for the metal gate electrodes include pure metals, metal nitrides and silicides, but in any case, it is required that (1) the threshold voltages (Vth) of the N-type MOSFET and the P-type MOSFET should permit setting to appropriate levels, (2) the gate insulating film should not be allowed to deteriorate when the metal gate electrodes are formed, and (3) the resistivity of the gate electrodes should be sufficiently low.

For devices operating with particularly low power among cutting-edge CMOS devices, the threshold voltages (Vth) of the CMOS transistors constituting the devices are set from ±0.25 to 0.5 eV. In order to realize this Vth level, it is necessary to use for a gate electrode material of which the work function is not greater than the mid-gap of Si (4.6 eV), desirably 4.5 to 4.3 eV, for N-type MOSFETs and one of which the work function is not smaller than the mid-gap (4.6 eV) of Si, desirably 4.7 to 4.9 eV, for P-type MOSFETs.

As means of realizing these objectives, a method of controlling the Vth of transistors by separately using different metals or alloys having different work functions for the electrodes of N-type MOSFETs and P-type MOSFETs (dual metal gate technique) is proposed.

For instance, it is stated in Non-Patent Document 1 (International electron devices meeting technical digest 2002, p. 359) that the work functions of Ta and Ru formed over SiO₂ are respectively 4.15 eV and 4.95 eV, and work function modulation by 0.8 eV is possible between these two electrodes.

As another dual metal gate technique, a technique by which a gate pattern comprising high melting point metals having their effective work functions in the vicinities of the mid-gap of silicon or their silicides is formed over a gate insulating film, impurities of mutually different types are added to the electrode part for P-type MOSFETs and the electrode part for N-type MOSFETs by ion implantation, followed by high temperature annealing to separately produce MOSFETs differing in effective work function is proposed. A feature of this technique consists in that virtually the same process as that of the related art can be applied, only differing in that polycrystalline silicon is replaced by high melting point metals or their silicides.

As another such technique, one by which an Mo silicide having a greater silicon (Si) content than in its stoichiometric composition is used as the gate electrode and the effective work function is controlled within a range of 4.2 to 5.1 eV by adding B and As respectively to the electrode part for P-type MOSFETs and the electrode part for N-type MOSFETs by ion implantation is disclosed in Non-Patent Document 2 (International electron devices meeting technical digest 1985, p. 415).

As a technique related thereto, one by which, after forming a gate pattern consisting of W silicide having a greater Si content than in its stoichiometric composition, a source/drain region is formed by ion implantation using this pattern as the mask, Ti films are formed over the upper face of the gate electrode and the upper face of the source/drain region, and Ti silicide is formed over the upper face of the gate electrode and the upper face of the source/drain region by subjecting the films to heat treatment is disclosed in Patent Document 1 (Japanese Patent Application Laid-Open No. 8-130216). It is stated that this technique can serve to improve the tightness of adhesion of the gate electrode to the base and reduce the resistance.

As still another dual metal gate technique, a full silicide technique by which a polycrystalline silicon electrode is fully silicided with Ni or some other metal to form a gate electrode is now attracting note. This technique is characterized in that it allows self-aligning silicidation of the polycrystalline silicon electrode pattern after high temperature heat treatment to activate impurities in the source/drain region of CMOS. For this reason, it is highly compatible with conventional CMOS processes and, because the film stacked over the gate insulating film need not be removed, damage to the gate insulating film can be suppressed.

In Non-Patent Document 3 (International electron devices meeting technical digest 2002, p. 247) and Non-Patent Document 4 (International electron devices meeting technical digest 2003, p. 315), techniques which enable the effective work function to be modulated by 0.5 eV at the maximum by using SiO₂ for the gate insulating film and using, as the gate electrode, Ni silicide electrodes (P doped NiSi; B doped NiSi) that are formed by fully siliciding a polycrystalline silicon electrode pattern doped with impurities P and B with Ni are disclosed.

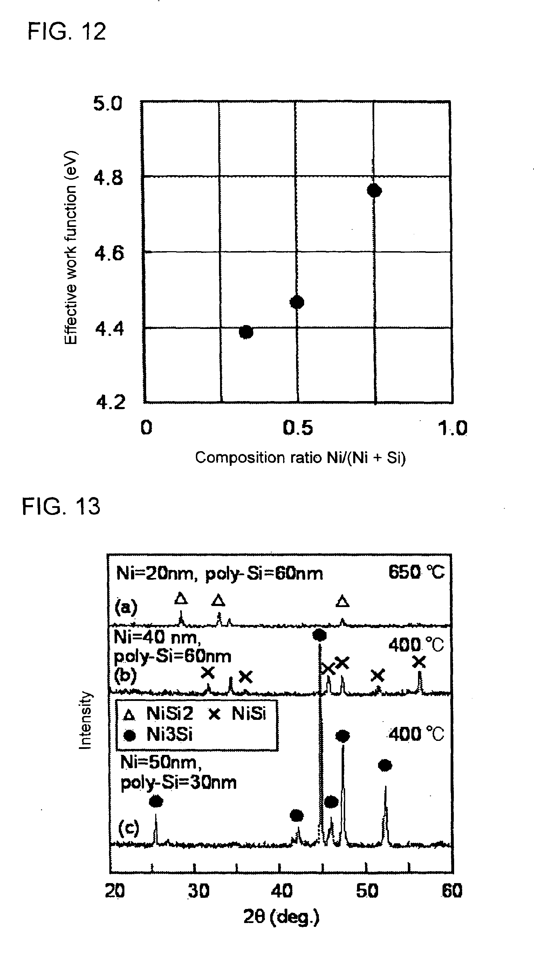

Also, Non-Patent Document 5 (International electron devices meeting technical digest 2004, p. 91) discloses a technique by which the effective work function is controlled, in a MOSFET using an HfSiON high dielectric constant film as the gate insulating film and a fully silicided Ni silicide electrode as the gate electrode, by controlling the composition of the Ni silicide by utilizing the formation of a crystalline phase (phase-controlled Ni full silicidation technique). By using this technique, a wide control range for the effective work function as shown in Figure 12 can be obtained. By using an Ni₃Si electrode for the P-type MOSFET and an NiSi₂ electrode for the N-type MOSFET herein, the Vth of the CMOS transistor can be set to ±0.3 V.

However, the techniques described above respectively involve the following problems.

Since the dual metal gate technique described in Non-Patent Document 1 requires separate preparation of different metals or alloys having different work functions, the gate material layer accumulated on the gate insulating film of either the P-type MOSFET or the N-type MOSFET has to be etched off. As this invites deterioration of the quality of the gate insulating film in the etching process, there is a problem of adversely affecting the characteristics and reliability of elements.

The technique by which a gate pattern comprising high melting point metals or their silicides is formed, impurities of mutually different types are added to the electrode part for P-type MOSFETs and the electrode part for N-type MOSFETs by ion implantation, followed by high temperature annealing to separately produce MOSFETs differing in effective work function, is apt to invite interfacial reaction between the gate insulating film and the gate electrode due to the high temperature annealing. As a result, the metals contained in the gate electrode may become diffused into the gate insulating film and thereby bring down the insulating property.

In a case where a high melting point metal silicide having a greater silicon (Si) content than in its stoichiometric composition is used as the gate electrode as disclosed in Non-Patent Document 2 and Patent Document 1, the composition may become uneven when forming the film of the high melting point metal silicide, or the diffusion of the impurities implanted into the gate electrode or the activation of the source/drain region may invite phase separation of the silicide during the high temperature annealing and resultant fluctuation of the effective work function with a possible consequence of adversely affecting the reproducibility and uniformity of the elements.

Especially the technique disclosed in Patent Document 1 by which a Ti silicide layer is stacked over W silicide inevitable invites the presence of W in the Ti silicide layer because a Ti film is formed over the W silicide gate electrode and Ti silicide is formed by diffusing Ti into the W silicide electrode by heat treatment. As a result, the Ti silicide layer formed over the W silicide electrode contains W as an impurity, and its resistivity becomes higher than that of Ti silicide of stoichiometric composition. As a consequence, it is difficult to sufficiently reduce the contact resistance of the W silicide gate electrode. When a Ti silicide is formed over W silicide, it is impossible to fully avoid mutual diffusion of Ti or W on the Ti silicide/W silicide interface, and therefore the difficulty to reduce resistance is an essential problem in this technique.

The techniques described in Non-Patent Documents 3 and 4 by which the effective work function is modulated by fully siliciding polycrystalline silicon doped with impurities involves the problem that, where a high dielectric constant material is used for the gate insulating film, the effective work function cannot be controlled.

On the other hand, the phase-controlled Ni full silicidation technique described in Non-Patent Document 5 is excellent in that the effective work function may be controlled in a broad range even when a high dielectric constant gate insulating film is used. However, a problem lies in the high resistivity levels of NiSi₂ phase most suitable for the NMOS electrode and the Ni₃Si phase most suitable for the PMOS electrode. Against the 10.4 µΩ cm resistivity of the NiSi phase, that of the NiSi₂ phase is 34 µΩ cm, and that of the metal-rich Ni silicide containing the Ni₃Si phase is 24 µΩ cm. Thus, on account of the weakness of the effect to reduce the gate wiring resistance, which is one of the advantages of metal gate electrode, there is a problem that the expected transistor performance characteristics cannot be obtained.

### Disclosure of the Invention

The present invention is intended to provide a technique by which a broad threshold control range can be obtained without sacrificing reliability and the resistivity of the gate electrode can be kept low, and to provide a semiconductor device excelling in performance and reliability by this technique and a manufacturing method thereof.

According to the invention, the following semiconductor devices and manufacturing methods thereof are provided.

(1) A semiconductor device comprising: a silicon substrate; a gate insulating film on the silicon substrate; a gate electrode on the gate insulating film; and source/drain regions formed in the substrate on both sides of the gate electrode, wherein the gate electrode comprises: a first silicide layered region formed of a silicide of a metal M1; and a second silicide layered region on the first silicide layered region, the second silicide layered region being formed of a silicide of the same metal as the metal M1 and being lower in resistivity than the first silicide layered region.

(2) The semiconductor device according to item (1), wherein each of the first silicide layered region and the second silicide layered region comprises a silicide crystalline phase having the stoichiometric composition thereof.

(3) The semiconductor device according to item (1) or (2), wherein the metal M1 is Ni.

(4) The semiconductor device according to item (3), wherein the second silicide layered region comprises an Ni monosilicide (NiSi) phase.

(5) The semiconductor device according to item (4), wherein the first silicide layered region comprises an NiSi₂ phase.

(6) The semiconductor device according to item (4), wherein the first silicide layered region comprises an Ni₃Si phase.

(7) The semiconductor device according to item (5), wherein the above gate electrode constitutes the gate electrode of an N-type MOS transistor.

(8) The semiconductor device according to item (6), wherein the above gate electrode constitutes the gate electrode of a P-type MOS transistor.

(9) The semiconductor device according to any one of items (1) to (8), wherein a silicide layer made of silicide having the same composition as the second silicide layered region is formed over the source/drain regions.

(10) The semiconductor device according to item (1), wherein the semiconductor device comprises:
   an N-type MOS transistor including, as said gate electrode, a gate electrode comprising a first silicide layered region comprising an NiSi₂ phase and a second silicide layered region comprising an Ni monosilicide (NiSi) phase and being formed on the first silicide layered region; and
   a P-type MOS transistor including, as said gate electrode, a gate electrode comprising a first silicide layered region comprising an Ni₃Si phase and a second silicide layered region comprising an Ni monosilicide (NiSi) phase and being formed on the first silicide layered region.

(11) The semiconductor device according to item (10) wherein an Ni monosilicide (NiSi) layer is formed over the source/drain region in the N-type MOS transistor and the P-type MOS transistor.

(12) The semiconductor device according to any one of items (1) to (11) wherein the gate insulating film comprises a high dielectric constant insulating film formed of a metal oxide, a metal silicate, a metal oxide containing nitrogen or a metal silicate containing nitrogen.

(13) The semiconductor device according to item (12) wherein the high dielectric constant insulating film contains Hf or Zr.

(14) The semiconductor device according to item (12) wherein the high dielectric constant insulating film contains HfSiON.

(15) The semiconductor device according to any one of items (12) to (14) wherein the high dielectric constant insulating film is in contact with the gate electrode.

(16) The semiconductor device according to any one of items (12) to (15) wherein the gate insulating film comprises a region of a silicon oxide film or a silicon oxynitride film and, on this region, a region of the high dielectric constant insulating film.

(17) A method of manufacturing the semiconductor device as stated in item (1), comprising:
   forming an insulating film for the gate insulating film over the silicon substrate;
   forming a gate pattern by forming a polycrystalline silicon film over the insulating film and working on the film;
   forming a source/drain region;
   forming an interlayer insulating film over the silicon substrate so as to cover the gate pattern;
   exposing the upper face of the gate pattern;
   forming a film of the metal M1 over the silicon substrate so as to cover the upper face of the gate pattern;
   forming a silicide S1 of the metal M1 for a first silicide layered region by conducting a first heat treatment so as to wholly silicide the gate pattern in the thickness direction;
   removing the unsilicided part of the metal M1;
   forming a film of the metal M1 so as to cover the upper face of the silicided gate pattern; and
   forming a second silicide layered region made up of a silicide S2 containing a greater quantity of the metal M1 than the silicide S1 of the first silicide layered region by conducting a second heat treatment so as to diffuse the metal M1 into the upper part of the gate pattern.

(18) A method of manufacturing the semiconductor device as stated in item (1), comprising:
   forming an insulating film for the gate insulating film over the silicon substrate;
   forming a gate pattern by forming a polycrystalline silicon film over the insulating film and working on the film;
   forming a source/drain region;
   forming an interlayer insulating film over the silicon substrate so as to cover the gate pattern;
   exposing the upper face of the gate pattern;
   forming a film of the metal M1 over the silicon substrate so as to cover the upper face of the gate pattern;
   forming a silicide S1 of the metal M1 for a first silicide layered region by conducting a first heat treatment so as to wholly silicide the gate pattern in the thickness direction;
   removing the unsilicided part of the metal M1;
   forming a film of silicon (Si) so as to cover the upper face of the silicided gate pattern; and
   forming a second silicide layered region made up of a silicide S2 containing a smaller quantity of the metal M1 than the silicide S1 of the first silicide layered region by conducting a second heat treatment so as to diffuse the metal M1 into the silicon film from the silicide S1.

(19) A method of manufacturing the semiconductor device as stated in item (1), comprising:
   forming an insulating film for the gate insulating film over the silicon substrate;
   forming a gate pattern by forming a polycrystalline silicon film over the insulating film and working on the film;
   forming a source/drain region;
   forming an interlayer insulating film over the silicon substrate so as to cover the gate pattern;
   exposing the upper face of the gate pattern;
   forming a film of the metal M1 over the silicon substrate so as to cover the upper face of the gate pattern;
   forming a silicide S1 of the metal M1 for a first silicide layered region by conducting a first heat treatment so as to wholly silicide the gate pattern in the thickness direction;
   removing the unsilicided part of the metal M1;
   exposing the source/drain region by removing the interlayer insulating film;
   forming a film of the metal M1 so as to cover the exposed upper face of the gate pattern and the exposed source/drain region; and
   forming a second silicide layered region made up of a silicide S2 containing a greater quantity of the metal M1 than the silicide S1 of the first silicide layered region by conducting a second heat treatment so as to diffuse the metal M1 into the upper part of the gate pattern, and at the same time forming a silicide layer lower in resistivity than the silicide S1 over the source/drain region.

(20) The semiconductor device manufacturing method according to item (19), wherein the first heat treatment is performed at a higher temperature than the second heat treatment.

(21) The semiconductor device manufacturing method according to any one of items (17) to (20), wherein Ni is used as the metal M1.

(22) The semiconductor device manufacturing method according to item (17), wherein:
   Ni is used as the metal M1;
   a silicide S1 comprising an Ni disilicide (NiSi₂) phase for the first silicide layered region of the gate electrode is formed by the first heat treatment; and
   a silicide S2 comprising an Ni monosilicide (NiSi) phase for the second silicide layered region of the gate electrode is formed by the second heat treatment.

(23) The semiconductor device manufacturing method according to item (18), wherein:
   Ni is used as the metal M1;
   a silicide S1 comprising an Ni₃Si phase for the first silicide layered region of the gate electrode is formed by the first heat treatment; and
   a silicide S2 comprising an Ni monosilicide (NiSi) phase for the second silicide layered region of the gate electrode is formed by the second heat treatment.

(24) The semiconductor device manufacturing method according to item (19), wherein:
   Ni is used as the metal M1;
   a silicide S1 comprising an Ni disilicide (NiSi₂) phase for the first silicide layered region of the gate electrode is formed by the first heat treatment; and
   a silicide S2 comprising an Ni monosilicide (NiSi) phase for the second silicide layered region of the gate electrode is formed by the second heat treatment, and at the same time a silicide layer comprising an Ni monosilicide (NiSi) phase is formed over the source/drain region.

(25) A method of manufacturing the semiconductor device as stated in item (10), comprising:
   forming an insulating film for the gate insulating film over the silicon substrate;
   forming a gate pattern by forming a polycrystalline silicon film over the insulating film and working on the film;
   forming a source/drain region;
   forming an interlayer insulating film over the silicon substrate so as to cover the gate pattern;
   exposing the upper face of the gate pattern;
   forming a first mask to cover the upper face of the gate pattern in a P-type MOSFET region;
   forming an Ni film so as to cover the exposed upper face of the gate pattern in an N-type MOSFET region;
   forming an NiSi₂ phase for a first silicide layered region of the N-type MOSFET by conducting a first heat treatment so as to wholly silicide the gate pattern in the N-type MOSFET region;
   removing the unsilicided part of Ni and the first mask;
   forming a second mask to cover the upper face of the gate pattern in an N-type MOSFET region;
   forming an Ni film so as to cover the exposed upper face of the gate pattern in the P-type MOSFET region;
   forming an Ni₃Si phase for the first silicide layered region of the P-type MOSFET by conducting a second heat treatment so as to wholly silicide the gate pattern in the P-type MOSFET region;
   removing the unsilicided part of Ni and the second mask;
   exposing the source/drain region by removing the interlayer insulating film;
   forming an Ni film so as to cover the exposed upper face of the gate pattern and the exposed source/drain region;
   forming a second silicide layered region comprising an NiSi phase by conducting a third heat treatment so as to diffuse Ni into the upper part of the gate pattern in the N-type MOSFET region, and at the same time forming a silicide layer comprising an NiSi phase over the source/drain region in the N-type MOSFET region and in the P-type MOSFET region;
   removing the unsilicided part of Ni;
   forming a silicon film all over; and
   forming a second silicide layered region comprising an NiSi phase by conducting a fourth heat treatment so as to diffuse Ni from the Ni₃Si phase into the silicon film in the P-type MOSFET region.

(26) The semiconductor device manufacturing method according to item (25), further comprising thinning of the thickness of the gate pattern in the P-type MOSFET region after removing the unsilicided part of Ni and the first mask, followed by formation of the Ni film so as to cover the exposed upper face of the gate pattern of the P-type MOSFET region.

According to the invention, a semiconductor device excelling in performance and reliability and a manufacturing method thereof can be provided. In particular, a semiconductor device which is controlled to a desired threshold without reducing reliability and in which the resistivity of the gate electrode can be kept low, resulting in high speed and ability to operate with reduced power consumption can be provided.

As the element structure according to the invention has a low resistance silicide layered region in the upper part of the gate electrode, the wiring resistance of the gate electrode can be kept low. Furthermore, since the lower layer part and the low resistance upper layer part of this gate electrode are formed of silicides of the same metal, its fabrication process can be simplified and the wiring resistance of the electrode can be kept sufficiently low. In addition, by making the silicide compositions of the lower layer part and the upper layer part of the gate electrode conform to their stoichiometric compositions, the stability against the fabrication process of the elements can be enhanced, and accordingly fluctuations in the element performance can be suppressed.

In the manufacturing method according to the invention, as it permits full silicidation of the gate electrode before the silicide layer is formed in the source/drain region to reduce the contact resistance, the temperature of heat treatment for this silicidation can be set without considering the heat resistance of the silicide layer of the source/drain region. Therefore, a full silicidation process by high temperature heat treatment can be accomplished while preventing diffusions of impurities in the extended diffusion region and in the source/drain region, and thus a gate electrode made up of a desired silicide can be obtained. In the manufacturing method according to the invention, since it permits simultaneous formation for the silicide layer for contact use of the source/drain region and the low resistance silicide layered region in the upper part of the gate electrode, the number of process steps can be reduced with a corresponding reduction in manufacturing cost.

### Brief Description of the Drawings

Figure 1 shows a sectional view of a semiconductor device according to the invention;
Figure 2 shows a sectional view of the semiconductor device according to the invention;
Figures 3 show process sectional views of a manufacturing method of the semiconductor device according to the invention;
Figures 4 show process sectional views of the manufacturing method of the semiconductor device according to the invention;
Figures 5 show process sectional views of the manufacturing method of the semiconductor device according to the invention;
Figures 6 show process sectional views of the manufacturing method of the semiconductor device according to the invention;
Figures 7 show process sectional views of the manufacturing method of the semiconductor device according to the invention;
Figures 8 show process sectional views of the manufacturing method of the semiconductor device according to the invention;
Figures 9 show process sectional views of the manufacturing method of the semiconductor device according to the invention;
Figures 10 show process sectional views of the manufacturing method of the semiconductor device according to the invention;
Figures 11 show process sectional views of the manufacturing method of the semiconductor device according to the invention;
Figure 12 shows a relationship between the composition and the effective work function of an Ni silicide electrode over HfSiON;
Figure 13 shows the result of X-ray diffraction measurement of the crystalline phase of Ni silicide;
Figures 14 (a) and (c) show the results of RBS measurement and Figures 14 (b) and (d) show the results of composition analysis by simulation, with regard to Ni silicides; and
Figures 15 (a) and (b) show compositional distributions in gate electrode sections of the semiconductor device according to the invention in the depthwise direction.

### Best Mode for Carrying Out the Invention

Exemplary embodiments will be described below with reference to drawings.

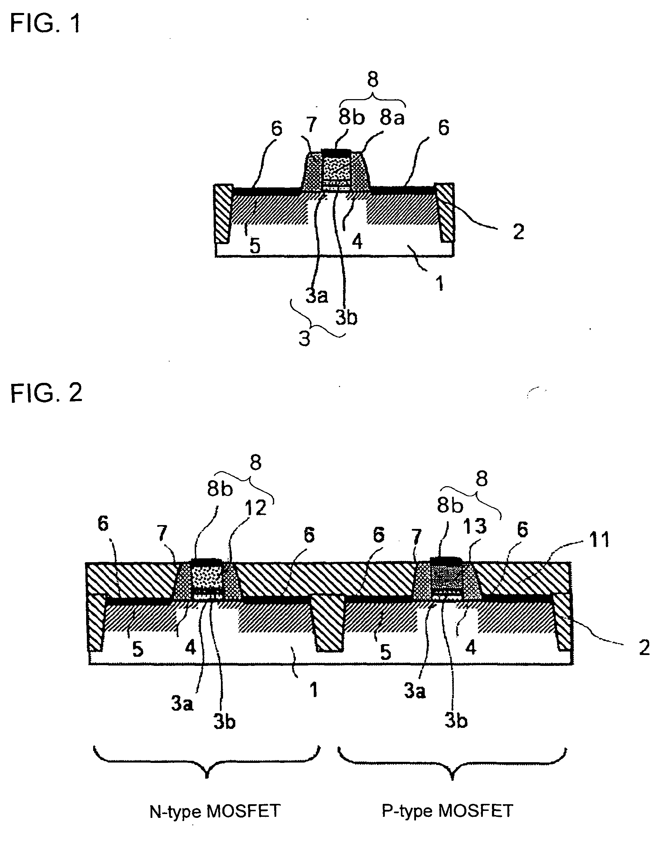

Figure 1 shows a sectional view of a semiconductor device according to an exemplary embodiment. As shown in Figure 1, gate insulating film 3 (having SiO₂ film 3a and HfSiON film 3b) is formed over the channel region of a silicon substrate 1, over which gate electrode 8 is formed. This gate electrode has a two-layered structure comprising a gate electrode lower part 8a in contact with the gate insulating film and a gate electrode upper part 8b (low resistance silicide layer) formed thereon. The gate electrode lower part 8a is formed of a silicide S1 obtained by depositing a metal over a gate pattern made up of polycrystalline silicon and fully siliciding the polycrystalline silicon by heat treatment. The gate electrode upper part 8b is formed of a silicide S2 of the same metal of the silicide making up the gate electrode lower part 8a. The resistivity of this silicide S2 is lower than the resistivity of the silicide S1 making up the gate electrode lower part 8a.

In the transistor having such a gate structure, it is desirable to use a high dielectric constant material for the gate insulating films 3. In the invention, by using the gate structure combined with a phase-controlled full silicidation technique the most effect can be obtained. The reason is that, as will be described afterwards, the phase-controlled full silicidation technique can realize a wide controllable range of the effective work function by using a high dielectric constant material for the gate insulating films 3.

Available gate insulating films using a high dielectric constant material include a high dielectric constant insulating film, a layered film comprising a silicon oxide film or a silicon oxynitride and a high dielectric constant insulating film stacked over any one of them. A high dielectric constant insulating film is made up of a material whose specific dielectric constant is greater than the specific dielectric constant of silicon dioxide (SiO₂), and such materials include metal oxides, metal silicates, metal oxides into which nitrogen is introduced and metal silicates into which nitrogen is introduced. A material into which nitrogen is introduced is more preferable because the nitrogen serves to suppress crystallization and enhance reliability. The preferable metal element to be contained in the high dielectric constant material is hafnium (Hf) or zirconium (Zr), of which Hf is particularly preferable, from the viewpoints of the thermal resistance of the film and suppression of the fixed electric charge in the film. Such high dielectric constant materials include metal oxides containing Hf or Zr and Si and such metal oxides further containing nitride are preferable, of which HfSiO and HfSiON are more preferable, especially HfSiON.

It is preferable for the average concentration ratio (ratio of the numbers of atoms) between Hf and Si (Hf/(Hf+Si)) if the HfSiON film is not less than 0.3 but not more than 0.7. If this ratio is not less than 0.3, the leak current flowing in the gate insulating film during device operation can be effectively suppressed, resulting in a sufficient reduction of power consumption. On the other hand, if this ratio is not more than 0.7, the thermal resistance of the HfSiON film can be secured, and the crystallization of and defect occurrence in the HfSiON film during the device fabrication process can be suppressed, thereby protecting the HfSiON film from deteriorating in reliability or performance.

It is preferable for the high dielectric constant insulating film to be disposed in contact with the gate electrode. The combination of the gate electrode and the high dielectric constant insulating film in contact with it enables the threshold voltage of the transistor to be controlled in a broad range. In this arrangement, in order to reduce the interface state between the silicon substrate and the gate insulating film and thereby decrease the influence of the fixed electric charge in the high dielectric constant insulating film, a silicon oxide film or a silicon oxynitride film may be provided on the interface between the high dielectric constant insulating film and the silicon substrate.

According to the invention, the gate electrode lower part 8a and the gate electrode upper part 8b are formed of silicides of the same metal differing from each other in compositional ratio. This enables the resistivity of the gate electrode upper part silicide layer 8b to be set to the minimum. On the other hand, where the metal of the silicide making up the gate electrode lower part differs from that of the silicide making up the gate electrode upper part, it is difficult to completely prevent reactions due to mutual diffusion or the like of silicide metals on the interface where the different silicides meet each other. For this reason, a ternary silicide layer containing the metal making up the gate electrode lower part is formed as the silicide layer of the gate electrode upper part. Such a ternary silicide cannot reduce resistivity as sufficiently as a single-phase silicide can. As a consequence, delays occur in the gate electrode wiring at the time of element operation, making it difficult for the element to achieve adequate element characteristics.

In implementing the invention, it is desirable for each of the silicide layers of the gate electrode lower part 8a and the gate electrode upper part 8b to have a crystalline phase and for the composition of each silicide to have a value matching the crystalline phase (stoichiometric composition). By conforming the composition of the silicide making up the gate electrode to its stoichiometric composition, it is made possible to realize silicide layers stable both thermally and electrically, eventually enabling the fluctuations of element performance to be suppressed.

In order to realize such a structure, it is desirable to form the gate electrode lower part 8a by a full silicidation technique in which a metal is deposited on polycrystalline silicon and subjected to heat treatment to completely silicify the polycrystalline silicon. Since the crystalline phase of a silicide is formed in a self-aligning manner by using the full silicidation technique, the silicide composition of the gate electrode lower part 8a can be conformed to its stoichiometric composition. Meanwhile, there is another method of forming the silicide electrode, which uses CVD as described in Patent Document 1 (Japanese Patent Application Laid-Open No. 8-130216). However, since CVD requires control of the composition of the silicide by regulating the flow rate ratio of process gas and the process temperature, it is difficult to control the composition in a self-aligning manner, and therefore it is far less easy to conform the composition of the gate electrode to its stoichiometric composition than by the full silicidation technique. Furthermore, the many rounds of heat treatment to which the silicide is exposed after the formation of the gate electrode are apt to invite phase separation of the silicide, possibly resulting in increased fluctuations of the element performance.

The desirable metal to be used in full silicidation of the gate electrode is one that permits complete silicidation at such a temperature that does not permit rediffusion of impurities in the source/drain region. More specifically, a metal that can be silicided at or below 700 °C is desirable. Also it is desirable to use a metal that can be silicided so as to form a plurality of types of crystalline phases having compositions of high metallic concentration to high Si concentration in such a temperature range. As the silicide's own work function varies with its composition, the effective work function is made controllable by utilizing the compositional variation of the silicide electrode due to the formation of the plurality of types of crystalline phase.

From this viewpoint of controlling the effective work function, it is preferable to use the aforementioned high dielectric constant material for the gate insulating film. By using high Si concentration silicide material for the gate of the N-type MOSFET and high metallic concentration silicide material for the gate of the P-type MOSFET as the gate electrodes over the high dielectric constant gate insulating film, it is made possible to obtain an extensive variation of the effective work function, greater than that of the silicide's own work function matching the silicide composition, with a slight change in silicide composition. This phenomenon is related to the Fermi level pinning of the electrode which arises when the polycrystalline silicon electrodes are formed on the high dielectric constant gate insulating film. For instance, when a silicide electrode of high Si concentration is formed on the high dielectric constant insulating film of HfSiON, the impact of the Fermi level pinning which arises on the polycrystalline silicon/HfSiON interface before the silicidation remains uneliminated. For this reason, the work function of the silicide electrode reaches a level close to 4.1 to 4.3 eV, which is the Fermi level pinning position of the polycrystalline silicon electrode on HfSiON. On the other hand, when the metallic concentration in the silicide electrode rises, the Fermi level pinning weakens, the level of the silicide's intrinsic work function comes to be substantially reflected. Thus, by forming silicide electrodes differing in crystalline phase on the high dielectric constant insulating film, an effect to ease the Fermi level pinning raises in addition to the variation of the silicide's own work function matching its composition, and a broader control range for the effective work function can be achieved than when an SiO₂ gate insulating film is used.

Ni is suitable as a metal to be silicided satisfying these conditions. The use of Ni enables polycrystalline silicon to be fully silicided by annealing at not more than 650 °C, and crystalline phases differing stepwise in composition can be formed by merely varying the supply quantity of Ni.

It is desirable for the low resistance Ni silicide making up the gate electrode upper part 8b to have an Ni monosilicide (NiSi) phase as its main component. Ni monosilicide is one of the silicides lowest in resistivity among all Ni-containing silicide materials, and it is made possible to minimize the contact resistance of the gate electrode by forming an NiSi layer in the gate electrode upper part.

It is desirable for the thickness TS2 of the NiSi layer to be formed in the gate electrode upper part 8b to be sufficiently great relative to the thickness TS1 of the gate electrode lower part 8a within the extent of not affecting the value of the effective work function determined by the silicide of the gate electrode lower part 8a. The reason is that the wiring resistance of the gate electrodes 8 having a two-layered structure decreases in proportion to the thickness of the low resistance silicide layer of the gate electrode upper part 8b. Where the silicide phases of the gate electrode lower parts 8a of the N-type MOSFET and of the P-type MOSFET differ from each other in a CMOS device, it is desirable to set the ratio between TS1 and TS2 with the FET of each in such a way as to equalize the gate electrode wiring resistances of the N-type MOSFET and of the P-type MOSFET.

For the reason stated above, in the configuration shown in Figure 2, it is preferable for the composition of the Ni silicide of the gate electrode lower part 8a, where at least the composition on the side in contact with the high dielectric constant insulating film, such as an HfSiON film, is represented by NiₓSi₁₋ₓ(0 < x < 1), to be 0.6 ≤ x < 1 in an Ni silicide 13 of the gate electrode lower part of the P-type MOSFET, more preferably 0.6 < x < 0.8, still more preferably 0.7 < x < 0.8, and to be 0 < x ≤ 0.5 in an Ni silicide 12 of the gate electrode lower part of the N-type MOSFET, more preferably 0.25 < x < 0.45, still more preferably 0.25 < x < 0.35. Whereas the crystalline phases of Ni silicides are classified mainly into NiSi₂, NiSi, Ni₃Si₂, Ni₂Si, Ni₃₁Si₁₂ and Ni₃Si, the average composition of the gate electrode may deviate from its stoichiometric composition because a mixture of these phases may be distributed in the gate electrode depending on the thermal hysteresis. Even in such a case, it is preferable for the electrode to stay within the above-stated range of composition. In order to minimize the fluctuations of element characteristics, it is desirable for the part of the gate electrode in contact with the gate insulating film to be made up of single crystalline phase wherever possible and to have a certain composition reflecting it. Thus, it is desirable for the silicide of the gate electrode lower part 13 of the P-type MOSFET to contain an Ni₃S phase as its main component and for the silicide of the gate electrode lower part 12 of the N-type MOSFET to contain an NiSi₂ phase as its main component.

The optimal threshold Vth (0.3 to 0.5 V) for the CMOS device operating with low power consumption can be realized with such a device structure, and further the contact resistance of the gate electrode can be reduced by forming the NiSi layer, which is a low resistance silicide layer, in the gate electrode upper part.

The term "high dielectric constant (high-k) film" in the context of this specification is used for distinction from the silicon dioxide (SiO₂) insulating film which has conventionally been in general use as a gate insulating film, and means the film has a higher dielectric constant than that of silicon dioxide, but is nothing to limit the specific numerical value thereof.

Further in this specification "the effective work function" or "the work function in effect" of the gate electrode is generally figured out from a flat band by CV measurement, and is affected by such factors as the fixed electric charge in the insulating film, the dipole on the interface and the Fermi level pinning in addition to the intrinsic work function of the gate electrode. It is distinguished from the intrinsic "work function" of the material making up the gate electrode.

Further in this specification, "MOS" (Metal Oxide Semiconductor) means a stacked structure of conductor, insulator and semiconductor, but not limited to one in which the conductor is a simple metal and the insulator is silicon dioxide.

Modes for carrying out the present invention will be described below with reference to drawings.

### [Exemplary Embodiment 1]

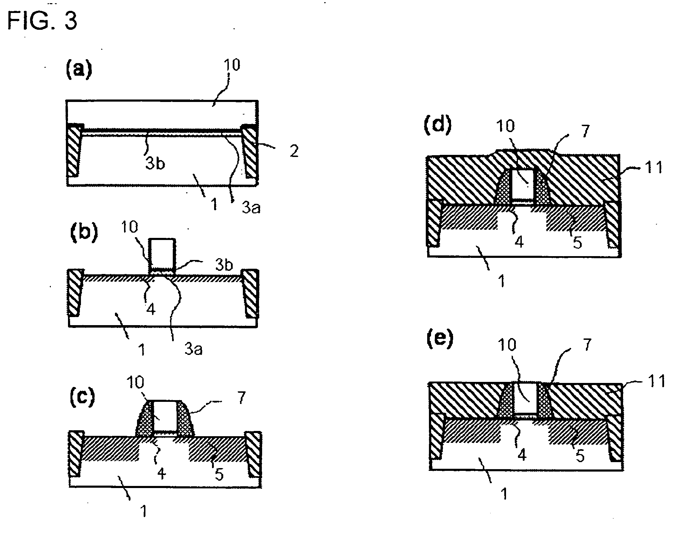

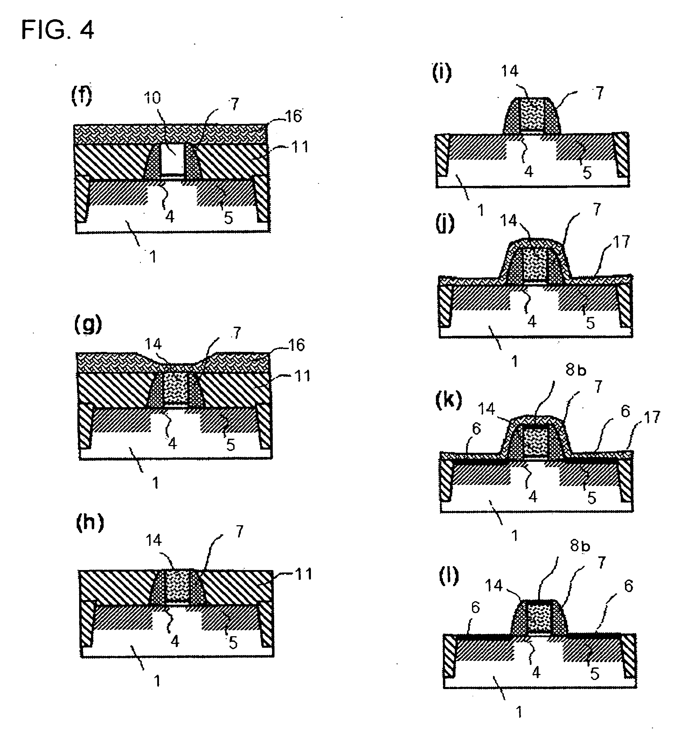

This exemplary embodiment is an example in which an NiSi₂ phase is formed in the gate electrode lower part, and an NiSi phase, in the upper part. Figures 3 (a) through (e) and Figures 4 (f) through (l) show sectional views of a MOSFET manufacturing process pertaining to this exemplary embodiment.

First, as shown Figure 3(a), an element isolating region 2 was formed in the surface region of the silicon substrate 1 by using an STI (Shallow Trench Isolation) technique. Then, the gate insulating film 3 (3a and 3b) was formed over the surface of the element-isolated silicon substrate. This gate insulating film had a structure comprising a silicon oxide film 3a and a high dielectric constant insulating film 3b. This exemplary embodiment used a gate insulating film having an HfSiON and SiO₂ composition in which the Hf concentration in the gate insulating film varied in the depthwise direction, the Hf concentration was the highest in the vicinities of the interface between the gate electrode and the gate insulating film, the average Hf concentration ratio Hf/(Hf + Si) in the HfSiON film was 0.5 and the vicinities of the interface between the silicon substrate and the gate insulating film had the composition of a thermally grown silicon oxide film. In order to obtain such a gate insulating film, after first forming a thermally grown silicon oxide film 3a of 1.9 nm, an HfSiO film was formed by depositing 0.5 nm Hf by long throw sputtering and subjecting Hf to solid phase diffusion into the base silicon oxide film by two-stage heat treatments first for 1 minute at 500 °C in oxygen and then for 30 seconds at 800 °C in nitrogen. It was followed by nitriding annealing for 10 minutes at 900 °C in an NH₃ atmosphere to obtain an HfSiON film 3b.

Next, after forming a polycrystalline silicon film 10 of 60 nm in thickness over the gate insulating film, this polycrystalline silicon film 10 was worked into a pattern having the dimensions of the gate electrode by using lithography and the RIE (Reactive Ion Etching) technique as shown in Figure 3(b). Then, by ion implantation using the polycrystalline silicon film 10 as the mask, an extended diffusion region 4 was formed in a self-aligning manner.

Next, as shown in Figure 3(c), a gate side wall 7 was formed by successively depositing a silicon nitride film and a silicon oxide film and etching back. In this state, ion implantation was carried out again, and the source/drain region 5 was formed via activating annealing.

Then, as shown in Figure 3(d), an interlayer insulating film 11 made up of a silicon oxide film was formed by CVD (Chemical Vapor Deposition). This interlayer insulating film 11 was flattened, as shown in Figure 3(e), by CMP (Chemical Mechanical Polishing), and the upper part surface of the polycrystalline silicon film 10 was exposed by etching back the vicinities of the surface of the interlayer insulating film 11 by treatment with HF solution.

Next, as shown in Figure 4(f), a first metal film 16 for siliciding the polycrystalline silicon film 10 was deposited. Whereas a metal capable of forming a silicide with the polycrystalline silicon film 10, for instance Ni, Pt, Hf, V, Ti, Ta, W, Co, Cr, Zr, Mo, Nb or an alloy of any one of these metals can be selected for the metal film, it is desirable to select what permits complete silicidation at a temperature which would not permit rediffusion of impurities in the extended diffusion region 4 and the source/drain region 5. More specifically, a metal that permits silicidation at or below 700 °C is desirable, and it is desirable to use a metal that can be silicided so as to form a plurality of types of crystalline phases having compositions of high metal concentration to high Si concentration in such a temperature range. In this exemplary embodiment, an Ni film was used as the first metal film 16 for full silicidation.

The Ni film thickness T at the formation step of the first metal film (Ni film) was set in such a way as to make the average composition of the silicide for gate use NiₓS₁₋ₓ (0.25 < x < 0.35) when the polycrystalline silicon film 10 and Ni sufficiently reacted to achieve silicidation. It is preferable to set such a film thickness as to enable the Ni silicide film in the part in contact with the gate insulating film having gone through siliciding reaction to contain an NiSi₂ phase as the main component. In this exemplary embodiment, an Ni film of 20 nm was formed at room temperature by DC magnetron sputtering. The electrode made up of Ni silicide containing the NiSi₂ phase formed in this exemplary embodiment as its main component has an effective work function of 4.4 to 4.5 eV over HfSiON. Since the optimal level of the effective work function is 4.4 to 4.5 eV in a low power consumption N-type MOSFET, the NiSi₂ electrode is suitable for use as the gate electrode of a low power consumption N-type MOSFET.

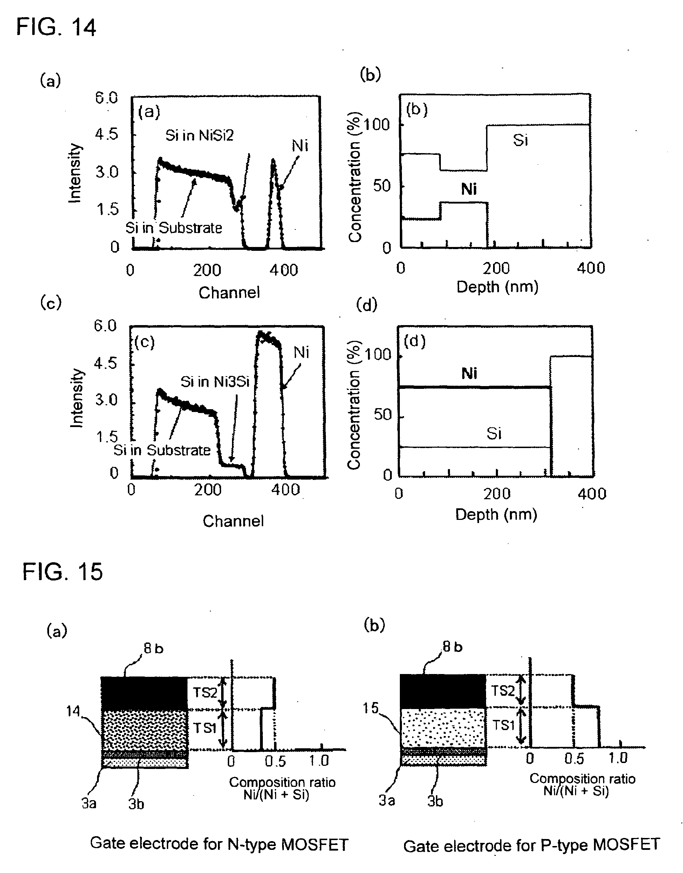

Next, heat treatment was performed to subject the polycrystalline silicon film 10 over the gate insulating film and the Ni film 16 to silicidation (Figure 4(g)). It is necessary not only that this heat treatment is performed in a non-oxidizing atmosphere to prevent oxidation of the Ni film, but also that a sufficient diffusion velocity is achieved for the polycrystalline silicon film 10 over the gate insulating film to be wholly silicided and that the temperature is kept at such a level that impurities in the extended diffusion region 4 and the source/drain region 5 are not rediffused. Incidentally, since the contact resistance reducing silicide layer (S/D silicide layer) is not yet formed over the source/drain region at this stage of the process by the manufacturing method according to the invention, the temperature of heat treatment can be determined without being constrained by the thermal resistance of the S/D silicide layer. In this exemplary embodiment, the treatment was performed for 1 minute at 650 °C in a nitrogen gas atmosphere in which an NiSi₂ phase could be obtained. From a silicide layer 14 for gate use, shown in Figure 4(g), formed under the conditions for full silicidation in this exemplary embodiment, peaks attributable to the NiSi₂ phase are clearly observed in X-ray diffraction (XRD) measurement shown in Figure 13(a). Furthermore, it was confirmed that the Ni and Si composition ratio was 1:2 on the interface between the gate electrode and the gate insulating film from the result of Rutherford backward scattering (RBS) measurement (Figure 14(a): result of RBS measurement; Figure 14(b): result of composition analysis by simulation).

Next, a surplus of the Ni film 16 which was not silicided by heat treatment was removed by wet etching using an aqueous solution of sulfuric acid and hydrogen peroxide (Figure 4(h)). Incidentally, in any part of the process described above, no peeling-off of the silicide electrode was ever observed.

Then, as shown in Figure 4(i), the interlayer insulating film 11 was wholly removed by dry etching to expose the upper surface of the NiSi₂ layer 14 and the source/drain region 5. Since the silicon oxide film making up the side wall of the gate then was vitrified firmly by activating annealing, the etching selection ratio to the interlayer insulating film was secured.

Next, as shown in Figure 4(j), a second metal film 17 of 20 nm in thickness was deposited all over by sputtering. An Ni film was used as the second metal film 17. By forming a low resistance NiSi layer (nickel monosilicide layer) by siliciding the source/drain region with this Ni film at the subsequent heat treatment step, the contact resistance of the source/drain can be kept to the minimum. Further in this exemplary embodiment, by depositing Ni over the upper part of the NiSi layer 14 for gate use and subjecting it to heat treatment, a low resistance NiSi layer (nickel monosilicide layer) can be formed in the gate electrode upper part as well.

Then, heat treatment was carried out and, with a gate side wall film 7 and the element isolating region 2 being used as the mask, NiSi layers (nickel monosilicide layers) 8b and 6 of about 30 nm in thickness were formed in the upper part of the NiSi₂ layer 14 for gate use and the source/drain region 5 (Figure 4(k)).

Finally, a surplus of the Ni film 17 which was not silicided by the heat treatment was removed by wet etching using an aqueous solution of sulfuric acid and hydrogen peroxide (Figure 4(l)).

By going through the process described above, the gate stack structure having the low resistance NiSi layer 8b over the NiSi₂ layer 14, shown in Figure 4(l), can be obtained. By obtaining such an element structure, the contact resistance of the gate electrode wiring part can be kept low.

Figure 15(a) shows the compositional distribution of the gate electrode having the NiSi layer 8b over the NiSi₂ layer 14. As shown in Figure 15(a), since the compositions of the lower part 14 and the upper part 8b of the gate electrode are determined in a self-aligning manner by utilizing the formation of the Ni silicide crystalline phase, a uniform composition can be obtained in each Ni silicide layer. Furthermore, the compositional variation on the interface between the upper part 8b and the lower part 14 of the gate electrode is steep. The effective work function of the gate electrode is determined by the composition of the gate electrode lower part 14. Further, the wiring resistance of the whole gate electrode can be regulated by varying the thickness TS2 of the gate electrode upper part.

By the manufacturing method according to the invention, the silicide gate electrode can be formed after high temperature annealing for activation of the source/drain region. For this reason, deterioration of the reliability of the element due to metal diffusion or the like into the gate insulating film invited by the high temperature annealing can be supressed. Further, as the silicide gate electrode is formed by using a full silicidation process in the manufacturing method according to the invention, the gate electrode having the stoichiometric composition can be formed in a self-aligning manner by forming a crystalline phase. As a result, the silicide electrode composition can realize a high level of uniformity, and the stoichiometric composition also ensures stability in the process after the silicide gate electrode formation. For this reason, fluctuations of the threshold Vth of the transistor can be suppressed and accordingly fluctuations of element performance can be restrained. Furthermore, as the polycrystalline silicon for gate use is fully silicided before the formation of the silicide layer for contact use in the source/drain region in the manufacturing method according to the invention, the temperature of heat treatment for silicidation is not limited by the thermal resistance of the silicide layer in the source/drain region. Therefore, within a range in which impurities in the extended diffusion region 4 and the source/drain region 5 are not rediffused, full silicidation by high temperature heat treatment can be carried out. In addition, as the Ni silicide layer for contact use in the source/drain region and the low resistance Ni silicide layer over the NiSi₂ electrode are formed together in the manufacturing method according to the invention, the number of process steps can be reduced, with a corresponding reduction in manufacturing cost.

### [Exemplary Embodiment 2]

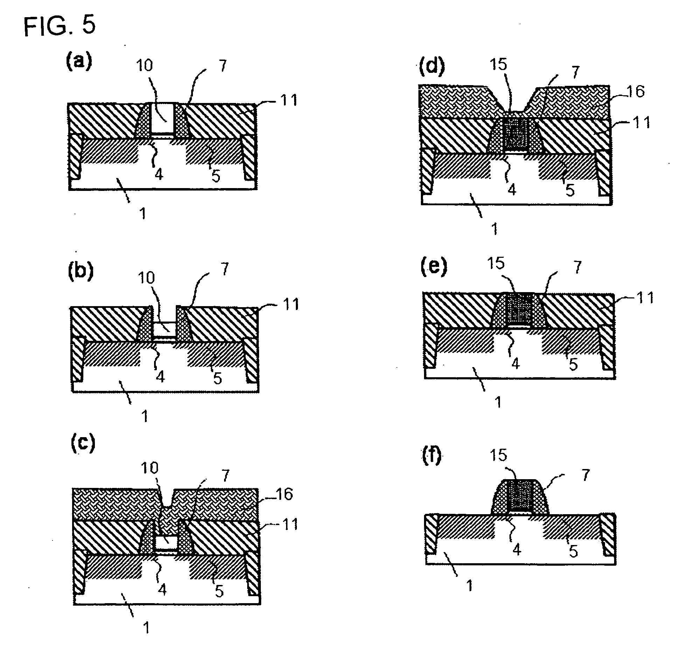

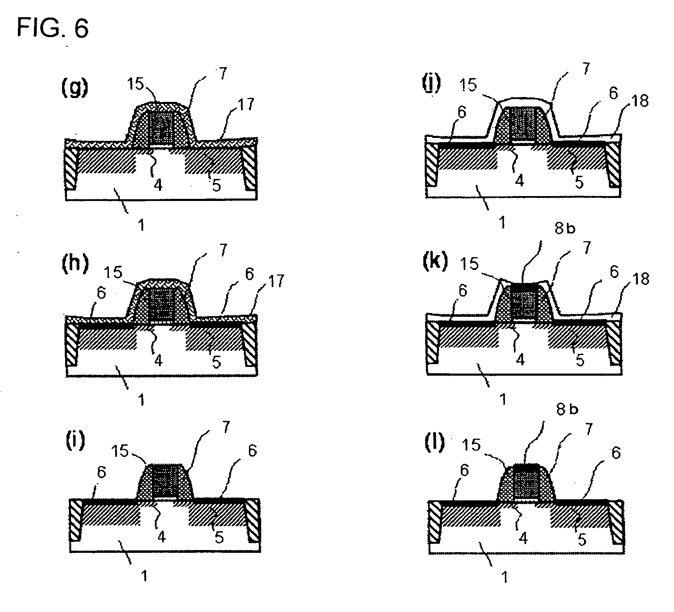

This is an example in which an Ni₃Si phase is formed in the gate electrode lower part, and an NiSi phase, in the upper part. Figures 5 (a) through (f) and Figures 6 (g) through (I) show sectional views of a MOSFET manufacturing process pertaining to this exemplary embodiment.

First, the upper part surface of the polycrystalline silicon film 10 for gate use is exposed as shown in Figure 5(a) by executing a similar process to that for Exemplary Embodiment 1 described with reference to Figures 3(a) through (e) above.

Then, the height of the polycrystalline silicon film 10 is reduced to half or less of that of the interlayer insulating film 11 by dry etching (Figure 5(b)). This is done because formation of the Ni₃Si layer by full silicidation technique lets the volume expansion due to silicidation make the height of the Ni₃Si layer double that of the polycrystalline silicon film 10 before the silicidation or even higher. If the height of the polycrystalline silicon film 10 is set to be about equal to that of the interlayer insulating film 11, the Ni₃Si electrode after the full silicidation will protrude from the interlayer insulating film. In a micro transistor whose gate length is 50 nm or less, such Ni₃Si protruding from the interlayer insulating film 11 is probably broken into particles to reduce the yield of transistor production. For this reason, the height of the polycrystalline silicon film 10 is reduced by dry etching so as to equalize the final height of the Ni₃Si electrode and the height of the interlayer insulating film 11. In this exemplary embodiment, the height of the polycrystalline silicon film 10 was reduced to 30 nm.

Next, as shown in Figure 5(c), the first metal film 16 for siliciding the polycrystalline silicon film 10 was deposited. Whereas a metal capable of forming a silicide with the polycrystalline silicon film 10, for instance Ni, Pt, Hf, V, Ti, Ta, W, Co, Cr, Zr, Mo, Nb or an alloy of any one of these metals can be selected for the metal film then, an Ni film was used as the first metal film 16 for full silicidation in this exemplary embodiment for the reason stated above.

The Ni film thickness T at the formation step of the first metal film (Ni film) was set in such a way as to make the average composition of the silicide for gate electrode use NiₓS₁₋ₓ (0.7 < x < 0.8) when the polycrystalline silicon film 10 and Ni sufficiently reacted to achieve silicidation. It is preferable to set such a film thickness as to enable the Ni silicide film in the part in contact with the gate insulating film having gone through siliciding reaction to contain an Ni₃Si phase as the main component. In this exemplary embodiment, an Ni film of 50 nm was formed at room temperature by DC magnetron sputtering. The electrode made up of Ni silicide containing the Ni₃Si phase as its main component on HfSiON in this exemplary embodiment has an effective work function of 4.7 to 4.8 eV. Since the optimal level of the effective work function is 4.7 to 4.8 eV in a low power consumption P-type MOSFET, the Ni₃Si electrode is suitable for use as the gate electrode of a low power consumption P-type MOSFET.

Next, heat treatment was performed to generate silicide reaction between the polycrystalline silicon film 10 on the gate insulating film and the Ni film 16 (Figure 5(d)). It is necessary not only that this heat treatment is performed in a non-oxidizing atmosphere to prevent oxidation of the Ni film, but also that a sufficient diffusion velocity is achieved for the polycrystalline silicon film 10 on the gate insulating film to be wholly silicided and that the temperature is kept at such a level that impurities in the extended diffusion region 4 and the source/drain region 5 are not rediffused. In this exemplary embodiment, the treatment was performed for 5 minutes at 400 °C in a nitrogen gas atmosphere in which an Ni₃Si phase could be obtained. From a silicide layer 15 for gate use, shown in Figure 5(d), formed under the conditions for full silicidation in this exemplary embodiment, peaks attributable to the Ni₃Si phase are clearly observed in X-ray diffraction (XRD) measurement shown in Figure 13(c). Furthermore, it was confirmed that the Ni and Si composition ratio was 3:1 on the interface between the gate electrode and the gate insulating film from the result of Rutherford backward scattering (RBS) measurement (Figure 14(c): result of RBS measurement; Figure 14(d): result of composition analysis by simulation).

Next, a surplus of the Ni film 16 which was not silicided by heat treatment was removed by wet etching using an aqueous solution of sulfuric acid and hydrogen peroxide (Figure 5(e)). Incidentally, in any part of the process described above, no peeling-off of the silicide electrode was ever observed.

Then, as shown in Figure 5(f), the interlayer insulating film 11 was wholly removed by dry etching to expose the upper surface of the Ni₃Si layer 15 and the source/drain region 5.

Next, as shown in Figure 6(g), the second metal film 17 of 20 nm in thickness was deposited all over by sputtering. An Ni film was used as the second metal film 17. By forming a low resistance NiSi layer by siliciding the source/drain region with this Ni film, the contact resistance of the source/drain can be kept to the minimum. Furthermore, even if Ni is deposited in the upper part of the Ni₃Si layer 15 for gate use and annealed, no crystalline phase of a still higher Ni concentration is formed, and therefore Ni is not diffused into the Ni₃Si layer.

Then, heat treatment was carried out and, with the gate side wall film 7, the element isolating region 2 and the Ni₃Si layer 15 for gate use being used as the mask, the nickel monosilicide layer (NiSi layer) 6 of about 30 nm in thickness was formed in the source/drain region 5 (Figure 6(h)).

Then, as shown in Figure 6(i), a surplus of the Ni film 17 which was not silicided by the heat treatment was removed by wet etching using an aqueous solution of sulfuric acid and hydrogen peroxide (Figure 6(i)).

Next, as shown in Figure 6(j), a silicon film 18 of 10 nm in thickness was deposited all over by sputtering.

After that, the NiSi layer (nickel monosilicide layer) 8b was selectively formed in the Ni₃Si layer upper part by performing heat treatment to react between the upper part of the Ni₃Si layer 15 and the silicon film 18 on it as shown in Figure 6(k). The temperature of the heat treatment to react between the Ni₃Si layer 15 and the silicon film 18 is required to be such a temperature that the NiSi layer 6 formed over the source/drain region does not undergo a phase change to the high resistance NiSi₂ and to be such a temperature that the Ni silicide layer 8b is formed, as a low resistance NiSi phase (nickel monosilicide phase), by Ni diffusion from the Ni₃Si layer 15 into the silicon film 18. More specifically, it is preferable to set the heat treatment temperature between 350 and 450 °C. In this exemplary embodiment, the heat treatment was carried out for 5 minutes at 400 °C in a nitrogen gas atmosphere.

Finally, a surplus of the silicon film 18 which was not silicided by the heat treatment was removed by dry etching as shown in Figure 6(l).

By going through the process described above, the gate stack structure having the low resistance NiSi layer 8b shown in Figure 6(I) can be obtained on the Ni₃Si layer 15. By obtaining such an element structure, the contact resistance of the gate electrode wiring part can be kept low.

Figure 15(b) shows the compositional distribution of the gate electrode having the NiSi layer 8b on the Ni₃Si layer 15. As shown in Figure 15(b), since the compositions of the lower part 15 and the upper part 8b of the gate electrode are determined in a self-aligning manner by utilizing the formation of the Ni silicide crystalline phase, a uniform composition can be obtained in each Ni silicide layer. Furthermore, the compositional variation on the interface between the upper part 8b and the lower part 15 of the gate electrode is steep. The effective work function of the gate electrode is determined by the composition of the gate electrode lower part 15. Further, the wiring resistance of the whole gate electrode can be regulated by varying the thickness TS2 of the gate electrode upper part.

### [Exemplary Embodiment 3]

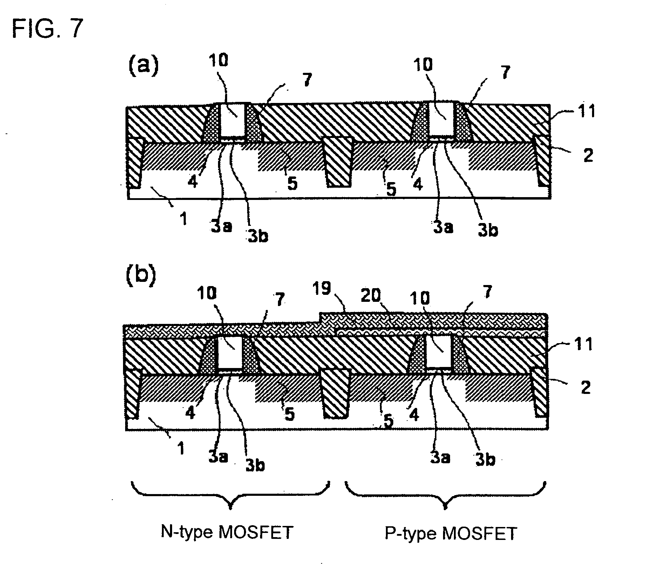

This is an example of fabricating a CMOS device in which an NiSi₂ phase is used in the gate electrode of the N-type MOSFET, and an Ni₃Si phase, in the gate electrode of the P-type MOSFET. Figures 7 through Figures 11 show sectional views of a MOSFET manufacturing process pertaining to this exemplary embodiment.

First, the upper part surface of the polycrystalline silicon film 10 for gate use is exposed as shown in Figure 7(a) by executing a similar process to that for Exemplary Embodiment 1 described with reference to Figures 3(a) through (e) above.

Next, a diffusion preventive layer 20 was deposited all over the wafer where the upper part surface of the polycrystalline silicon film 10 was exposed. This diffusion preventive layer 20 is intended to prevent metal from a first metal film 19 for forming the silicide electrode of the N-type MOSFET from being diffused into the polycrystalline silicon film in the P-type MOSFET region. It is required for this diffusion preventive layer 20 to be able to prevent a metal 19 for silicidation from being diffused into the polycrystalline silicon film at the heat treatment step for fully siliciding a polycrystalline silicon layer 10 for gate use and to be stable in itself. It is further preferable for this diffusion preventive layer 20 to be capable of being selectively etched to the silicided metal and the interlayer insulating film. In this exemplary embodiment, TiN of 20 nm was deposited by reactive sputtering at 300 °C. After that, only the TiN film in the N-type MOSFET region was removed by using lithography and RIE technique as shown in Figure 7(b) to expose the polycrystalline silicon film 10.

Next, as shown in Figure 7(b), the first metal film 19 for siliciding the polycrystalline silicon film 10 for gate use in the N-type MOSFET region was formed all over. Whereas a metal capable of forming a silicide with the polycrystalline silicon film 10, for instance Ni, Pt, Hf, V, Ti, Ta, W, Co, Cr, Zr, Mo, Nb or an alloy of any one of these metals can be selected for the metal film then, an Ni film was used as the first metal film 19 in this exemplary embodiment for the reason stated above.

The Ni film thickness T at the formation step of the first metal film (Ni film) was set in such a way as to make the average composition of the silicide for gate use NiₓS₁₋ₓ (0.25 < x < 0.35) when the polycrystalline silicon film 10 and Ni sufficiently reacted to achieve silicidation. It is preferable to set such a film thickness as to enable the Ni silicide film in the part in contact with the gate insulating film having gone through siliciding reaction to contain an NiSi₂ phase as the main component. In this exemplary embodiment, an Ni film of 20 nm was formed at room temperature by DC magnetron sputtering. The electrode made up of Ni silicide containing the NiSi₂ phase as its main component on HfSiON in this exemplary embodiment has an effective work function of 4.4 to 4.5 eV. Since the optimal level of the effective work function is 4.4 to 4.5 eV in a low power consumption N-type MOSFET, the NiSi₂ electrode is suitable for use as the gate electrode of a low power consumption N-type MOSFET.

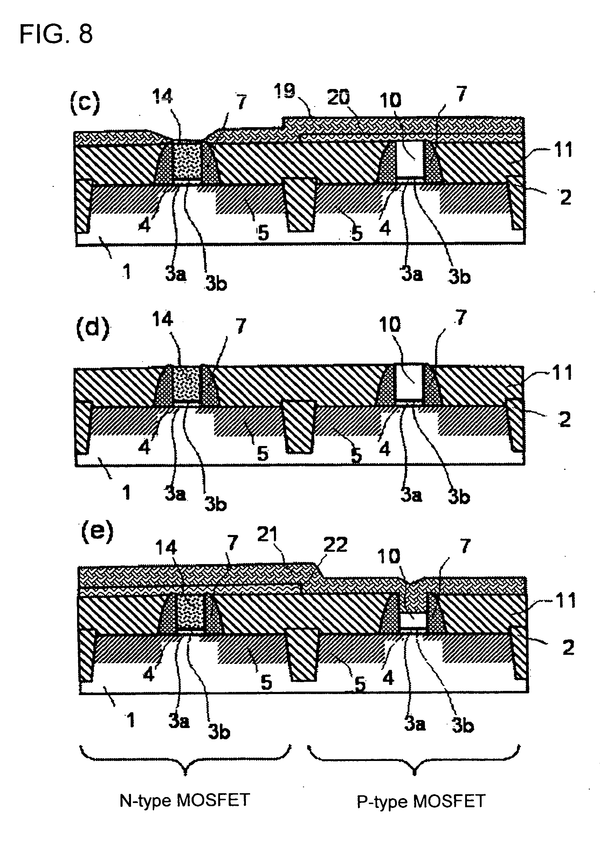

Next, heat treatment was performed to generate silicide reaction between the polycrystalline silicon film 10 on the gate insulating film in the N-type MOSFET region and the Ni film 19 as shown in Figure 8(c). In this exemplary embodiment, the treatment was performed for 1 minute at 650 °C in a nitrogen gas atmosphere in which an NiSi₂ phase could be obtained.

Next, surpluses of the Ni film 19 which were not silicided by heat treatment and the diffusion preventive layer 20 were removed by wet etching using an aqueous solution of sulfuric acid and hydrogen peroxide (Figure 8(d)). Incidentally, in any part of the process described above, no peeling-off of the silicide electrode was ever observed.

Then, the height of the polycrystalline silicon film 10 in the P-type MOSFET region is reduced to half or less of that of the interlayer insulating film 11 by dry etching (Figure 8(e)). This is done because formation of the Ni₃Si layer for the P-type MOSFET by full silicidation technique lets the volume expansion due to silicidation make the height of the Ni₃Si layer double that of the polycrystalline silicon film 10 before the silicidation or even higher. If the height of the polycrystalline silicon film 10 is set to be about equal to that of the interlayer insulating film 11, the Ni₃Si electrode after the full silicidation will protrude from the interlayer insulating film. In a micro transistor whose gate length is 50 nm or less, such Ni₃Si protruding from the interlayer insulating film 11 is probably broken into particles to reduce the yield of transistor production. For this reason, the height of the polycrystalline silicon film 10 is reduced by dry etching so as to equalize the final height of the Ni₃Si electrode and the height of the interlayer insulating film 11. In this exemplary embodiment, the height of the polycrystalline silicon film 10 was reduced to 30 nm.

Next, a diffusion preventive layer 22 for a second metal film 21 for forming a silicide for the P-type MOSFET gate was deposited all over a wafer including the exposed part of a silicide 14 for the gate in the N-type MOSFET region. In this exemplary embodiment, TiN of 20 nm in thickness was deposited by reactive sputtering at 300 °C for the reason stated above. Then, only the TiN film in the P-type MOSFET region was removed by using lithography and RIE technique as shown in Figure 8(e) to expose the polycrystalline silicon film 10. After that, the second metal film 21 for forming the silicide electrode for the P-type MOSFET was formed all over. Whereas a metal capable of forming a silicide with the polycrystalline silicon film 10, for instance Ni, Pt, Hf, V, Ti, Ta, W, Co, Cr, Zr, Mo, Nb or an alloy of any one of these metals can be selected for the metal film then, Ni was used in this exemplary embodiment for the reason stated above.

The Ni film thickness T at the formation step of the second metal film 21 was so set as to make the average composition of the silicide for gate use NiₓS₁₋ₓ (0.7 < x < 0.8) when the polycrystalline silicon film 10 and Ni sufficiently reacted to achieve silicidation. It is preferable to set such a film thickness as to enable the Ni silicide film in the part in contact with the gate insulating film having gone through siliciding reaction to contain an Ni₃Si phase as the main component. In this exemplary embodiment, an Ni film of 50 nm was formed at room temperature by DC magnetron sputtering. The electrode made up of Ni silicide containing the Ni₃Si phase as its main component on HfSiON in this exemplary embodiment has an effective work function of 4.7 to 4.8 eV. Since the optimal level of the effective work function is 4.7 to 4.8 eV in a low power consumption P-type MOSFET, the Ni₃Si electrode is suitable for use as the gate electrode of a low power consumption P-type MOSFET.

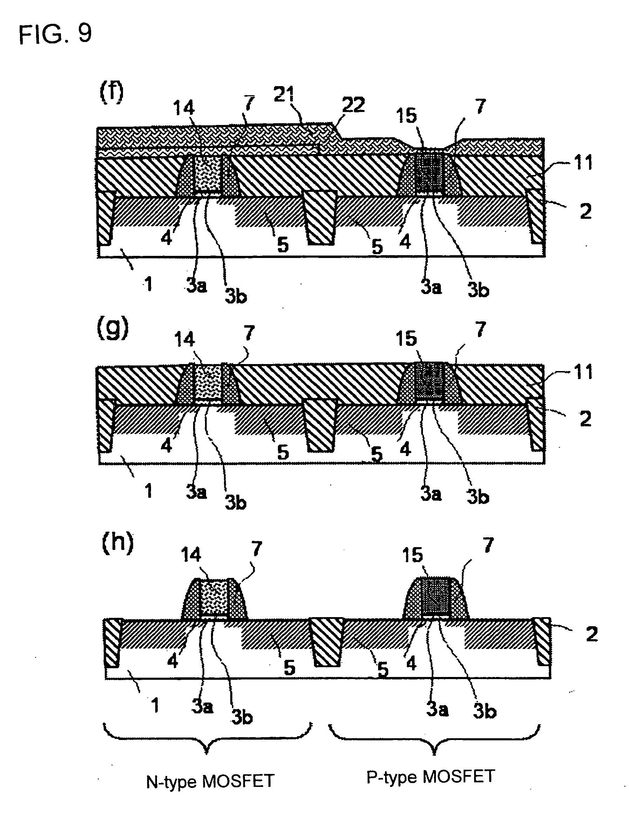

Next, as shown in Figure 9(f), heat treatment was performed to generate silicide reaction between the polycrystalline silicon film 10 on the gate insulating film in the P-type MOSFET region and the Ni film 21. In this exemplary embodiment, the treatment was performed for 5 minutes at 400 °C in a nitrogen gas atmosphere in which an Ni₃Si phase could be obtained.

Next, surpluses of the Ni film 21 which were not silicided by heat treatment and the diffusion preventive layer 22 were removed by wet etching using an aqueous solution of sulfuric acid and hydrogen peroxide (Figure 9(g)). Incidentally, in any part of the process described above, no peeling-off of the silicide electrode was ever observed.

In the process described above, the NiSi₂ phase was formed as the silicide 14 for the N-type MOSFET gate and the Ni₃Si phase, as the silicide 15 for the P-type MOSFET gate.

Next, as shown in Figure 9(h), the interlayer insulating film 11 was wholly removed by dry etching to expose the upper surfaces of the Ni silicides 14 and 15 for gate use and the source/drain region 5.

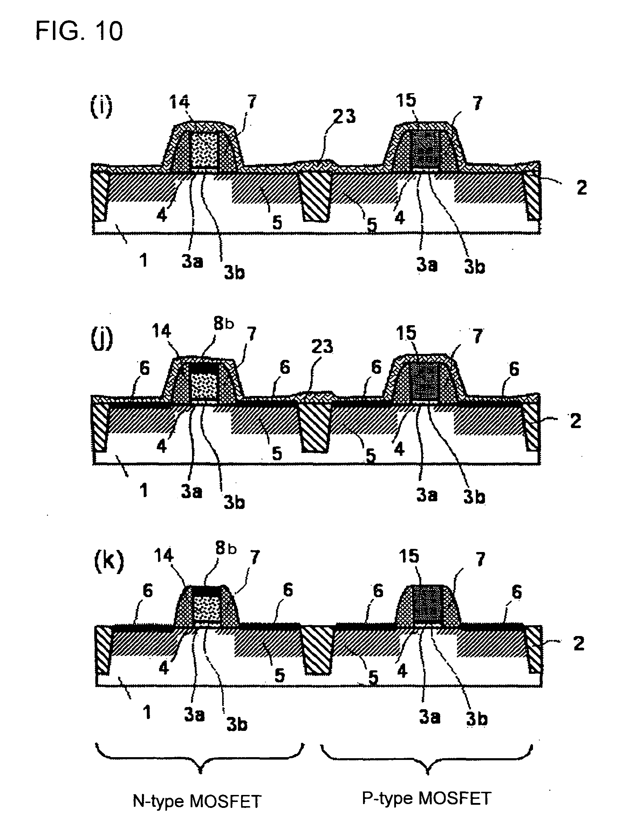

Next, as shown in Figure 10(i), a third metal film 23 of 20 nm in thickness was deposited all over by sputtering. An Ni film was used as the third metal film 23. By forming a low resistance NiSi layer by siliciding the source/drain region with this Ni film, the contact resistance of the source/drain can be reduced to the minimum. Furthermore, since the silicide 14 for gate use is NiSi₂, a low resistance NiSi layer (nickel monosilicide phase) can also be formed in the upper part of the gate electrode by depositing Ni in the upper part of the NiSi₂ layer and annealing it. On the other hand, since the silicide 15 for gate use in the P-type MOSFET region is Ni₃Si, even if Ni is deposited in the upper part of the Ni₃Si layer 15 and annealed, no crystalline phase of a still higher Ni concentration is formed, and therefore Ni is not diffused into the Ni₃Si layer.

Then, heat treatment was carried out and, with the gate side wall film 7 and the element isolating region 2 being used as the mask, the nickel monosilicide (NiSi) layers 8 and 6 of about 30 nm in thickness were formed on the NiSi₂ layer 14 and on the source/drain region 5 (Figure 10(j)).

Then, as shown in Figure 10(k), a surplus of the Ni film 23 which was not silicided by the heat treatment was removed by wet etching using an aqueous solution of sulfuric acid and hydrogen peroxide.

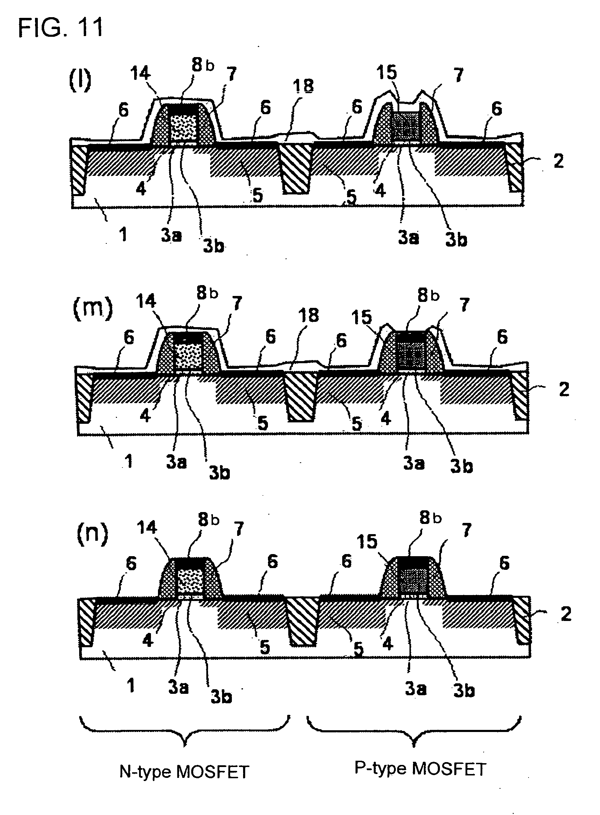

Next, as shown in Figure 11 (l), the silicon film 18 of 10 nm in thickness was deposited all over by sputtering.

After that, the NiSi layer (nickel monosilicide layer) 8b was selectively formed in the Ni₃Si layer upper part by annealing to react between the upper part of the Ni₃Si layer 15 and the silicon film 18 on it as shown in Figure 11 (m). The temperature of the annealing to react between the Ni₃Si layer 15 and the silicon film 18 is required to be such a temperature that the NiSi layer 6 formed over the source/drain region 5 and the NiSi₂ layer 14 of the N-type MOSFET do not undergo a phase change to the high resistance NiSi₂ and to be such a temperature that the Ni silicide layer 8b is formed, as a low resistance NiSi phase (nickel monosilicide phase), by Ni diffusion from the Ni₃Si layer 15 into the silicon film 18. More specifically, it is preferable to set the heat treatment temperature in the range of 350 °C to 450 °C. In this exemplary embodiment, the heat treatment was carried out for 5 minutes at 400 °C in a nitrogen gas atmosphere.

Finally, a surplus of the silicon film 18 which was not silicided by the heat treatment was removed by dry etching as shown in Figure 11 (n).

By going through the process described above, the gate stack structure having the low resistance NiSi layer 8b over the NiSi₂ layer 14 and the Ni₃Si layer 15 as shown in Figure 11 (n) can be obtained. By obtaining such an element structure, the contact resistance of the gate electrode wiring part can be kept low. Further, the optimal threshold Vth (0.3 to 0.5 V) for the low power consumption CMOS device can be realized with such a device structure.

While exemplary embodiments of the present invention have been described so far, the invention is not limited to these exemplary embodiments, but can be implemented by selecting suitable materials and structures without deviating from the true spirit and scope of the invention. For instance, the silicide metal making up the two layered gate electrodes is not limited to Ni if the silicides can form mutually different crystalline phases within a range of not allowing the contact resistance in the source/drain region and the impurities profile in the diffused region to deteriorate in the full silicidation process and if sufficiently low resistivity silicide layers can be formed of the same metal over the silicide layers of the gate electrodes.

## Claims

1. A semiconductor device comprising:
a silicon substrate;
a gate insulating film on the silicon substrate;
a gate electrode on the gate insulating film; and
source/drain regions formed in the substrate on both sides of the gate electrode,
wherein the gate electrode comprises:
a first silicide layered region formed of a silicide of a metal M1; and
a second silicide layered region on the first silicide layered region, the second silicide layered region being formed of a silicide of the same metal as the metal M1 and being lower in resistivity than the first silicide layered region.

2. The semiconductor device according to claim 1, wherein each of the first silicide layered region and the second silicide layered region comprises a silicide crystalline phase having the stoichiometric composition thereof.

3. The semiconductor device according to claim 1 or 2, wherein the metal M1 is Ni.

4. The semiconductor device according to claim 3, wherein the second silicide layered region comprises an Ni monosilicide (NiSi) phase.

5. The semiconductor device according to claim 4, wherein the first silicide layered region comprises an NiSi₂ phase.

6. The semiconductor device according to claim 4, wherein the first silicide layered region comprises an Ni₃Si phase.

7. The semiconductor device according to claim 5, wherein said gate electrode constitutes the gate electrode of an N-type MOS transistor.

8. The semiconductor device according to claim 6, wherein said gate electrode constitutes the gate electrode of a P-type MOS transistor.

9. The semiconductor device according to any one of claims 1 to 9, wherein a silicide layer made of silicide having the same composition as the second silicide layered region is formed over the source/drain regions.

10. The semiconductor device according to claim 1, wherein the semiconductor device compries:
an N-type MOS transistor including, as said gate electrode, a gate electrode comprising a first silicide layered region comprising an NiSi₂ phase and a second silicide layered region comprising an Ni monosilicide (NiSi) phase and being formed on the first silicide layered region; and
a P-type MOS transistor including, as said gate electrode, a gate electrode comprising a first silicide layered region comprising an Ni₃Si phase and a second silicide layered region comprising an Ni monosilicide (NiSi) phase and being formed on the first silicide layered region.

11. The semiconductor device according to claim 10, wherein an Ni monosilicide (NiSi) layer is formed over the source/drain region in the N-type MOS transistor and the P-type MOS transistor.

12. The semiconductor device according to any one of claims 1 to 11, wherein the gate insulating film comprises a high dielectric constant insulating film formed of a metal oxide, a metal silicate, a metal oxide containing nitrogen or a metal silicate containing nitrogen.

13. The semiconductor device according to claim 12, wherein the high dielectric constant insulating film contains Hf or Zr.

14. The semiconductor device according to claim 12, wherein the high dielectric constant insulating film contains HfSiON.

15. The semiconductor device according to any one of claims 12 to 14, wherein the high dielectric constant insulating film is in contact with the gate electrode.

16. The semiconductor device according to any one of claims 12 to 15, wherein the gate insulating film comprises a region of a silicon oxide film or a silicon oxynitride film and, on this region, a region of the high dielectric constant insulating film.

17. A method of manufacturing the semiconductor device as recited in claim 1, comprising:
forming an insulating film for the gate insulating film over the silicon substrate;
forming a gate pattern by forming a polycrystalline silicon film over the insulating film and working on the film;
forming a source/drain region;
forming an interlayer insulating film over the silicon substrate so as to cover the gate pattern;
exposing the upper face of the gate pattern;
forming a film of the metal M1 over the silicon substrate so as to cover the upper face of the gate pattern;
forming a silicide S1 of the metal M1 for a first silicide layered region by conducting a first heat treatment so as to wholly silicide the gate pattern in the thickness direction;
removing the unsilicided part of the metal M1;
forming a film of the metal M1 so as to cover the upper face of the silicided gate pattern; and
forming a second silicide layered region made up of a silicide S2 containing a greater quantity of the metal M1 than the silicide S1 of the first silicide layered region by conducting a second heat treatment so as to diffuse the metal M1 into the upper part of the gate pattern.

18. A method of manufacturing the semiconductor device as recited in claim 1, comprising:
forming an insulating film for the gate insulating film over the silicon substrate;
forming a gate pattern by forming a polycrystalline silicon film over the insulating film and working on the film;
forming a source/drain region;
forming an interlayer insulating film over the silicon substrate so as to cover the gate pattern;
exposing the upper face of the gate pattern,
forming a film of the metal M1 over the silicon substrate so as to cover the upper face of the gate pattern;
forming a silicide S1 of the metal M1 for a first silicide layered region by conducting a first heat treatment so as to wholly silicide the gate pattern in the thickness direction;
removing the unsilicided part of the metal M1;
forming a film of silicon (Si) so as to cover the upper face of the silicided gate pattern; and
forming a second silicide layered region made up of a silicide S2 containing a smaller quantity of the metal M1 than the silicide S1 of the first silicide layered region by conducting a second heat treatment so as to diffuse the metal M1 into the silicon film from the silicide S1.

19. A method of manufacturing the semiconductor device as recited in claim 1, comprising:
forming an insulating film for the gate insulating film over the silicon substrate;
forming a gate pattern by forming a polycrystalline silicon film over the insulating film and working the film;
forming a source/drain region;
forming an interlayer insulating film over the silicon substrate so as to cover the gate pattern;
exposing the upper face of the gate pattern;
forming a film of the metal M1 over the silicon substrate so as to cover the upper face of the gate pattern;
forming a silicide S1 of the metal M1 for a first silicide layered region by conducting a first heat treatment so as to wholly silicide the gate pattern in the thickness direction;
removing the unsilicided part of the metal M1;
exposing the source/drain region by removing the interlayer insulating film;
forming a film of the metal M1 so as to cover the exposed upper face of the gate pattern and the exposed source/drain region; and
forming a second silicide layered region made up of a silicide S2 containing a greater quantity of the metal M1 than the silicide S1 of the first silicide layered region by conducting a second heat treatment so as to diffuse the metal M1 into the upper part of the gate pattern, and at the same time forming a silicide layer lower in resistivity than the silicide S1 over the source/drain region.

20. The semiconductor device manufacturing method according to claim 19, wherein the first heat treatment is performed at a higher temperature than the second heat treatment.

21. The semiconductor device manufacturing method according to any one of claims 17 to 20, wherein Ni is used as the metal M1.

22. The semiconductor device manufacturing method according to claim 17, wherein:
Ni is used as the metal M1;
a silicide S1 comprising an Ni disilicide (NiSi₂) phase for the first silicide layered region of the gate electrode is formed by the first heat treatment; and
a silicide S2 comprising an Ni monosilicide (NiSi) phase for the second silicide layered region of the gate electrode is formed by the second heat treatment.

23. The semiconductor device manufacturing method according to claim 18, wherein:
Ni is used as the metal M1;
a silicide S1 comprising an Ni₃Si phase for the first silicide layered region of the gate electrode is formed by the first heat treatment; and
a silicide S2 comprising an Ni monosilicide (NiSi) phase for the second silicide layered region of the gate electrode is formed by the second heat treatment.

24. The semiconductor device manufacturing method according to claim 19, wherein:
Ni is used as the metal M1;
a silicide S1 comprising an Ni disilicide (NiSi₂) phase for the first silicide layered region of the gate electrode is formed by the first heat treatment; and
a silicide S2 comprising an Ni monosilicide (NiSi) phase for the second silicide layered region of the gate electrode is formed by the second heat treatment, and at the same time a silicide layer comprising an Ni monosilicide (NiSi) phase is formed over the source/drain region.

25. A method of manufacturing the semiconductor device as recited in claim 10, comprising:
forming an insulating film for the gate insulating film over the silicon substrate;
forming a gate pattern by forming a polycrystalline silicon film over the insulating film and working on the film;
forming a source/drain region;
forming an interlayer insulating film over the silicon substrate so as to cover the gate pattern;
exposing the upper face of the gate pattern;
forming a first mask to cover the upper face of the gate pattern in a P-type MOSFET region;
forming an Ni film so as to cover the exposed upper face of the gate pattern in an N-type MOSFET region;
forming an NiSi₂ phase for a first silicide layered region of the N-type MOSFET by conducting a first heat treatment so as to wholly silicide the gate pattern in the N-type MOSFET region,
removing the unsilicided part of Ni and the first mask;
forming a second mask to cover the upper face of the gate pattern in an N-type MOSFET region;
forming an Ni film so as to cover the exposed upper face of the gate pattern in the P-type MOSFET region;
forming an Ni₃Si phase for the first silicide layered region of the P-type MOSFET by conducting a second heat treatment so as to wholly silicide the gate pattern in the P-type MOSFET region;
removing the unsilicided part of Ni and the second mask;
exposing the source/drain region by removing the interlayer insulating film;
forming an Ni film so as to cover the exposed upper face of the gate pattern and the exposed source/drain region;
forming a second silicide layered region comprising an NiSi phase by conducting a third heat treatment so as to diffuse Ni into the upper part of the gate pattern in the N-type MOSFET region, and at the same time forming a silicide layer comprising an NiSi phase over the source/drain region in the N-type MOSFET region and in the P-type MOSFET region;
removing the unsilicided part of Ni;
forming a silicon film all over; and
forming a second silicide layered region comprising an NiSi phase by conducting a fourth heat treatment so as to diffuse Ni from the Ni₃Si phase into the silicon film in the P-type MOSFET region.

26. The semiconductor device manufacturing method according to claim 25, further comprising thinning of the thickness of the gate pattern in the P-type MOSFET region after removing the unsilicided part of Ni and the first mask, followed by formation of the Ni film so as to cover the exposed upper face of the gate pattern of the P-type MOSFET region.
